# EUROPÄISCHE PATENTSCHRIFT

(11) **EP 1 733 600 B1**
(45) Veröffentlichungstag und Bekanntmachung des Hinweises auf die Patenterteilung: **17.11.2010**
(21) Anmeldenummer: 05717080.5
(22) Anmeldetag: 16.03.2005
(51) Int. Cl.: H05K 7/14, H01R 11/11

(54) **MOTORSTEUERGERÄT**
ENGINE CONTROL DEVICE
APPAREIL DE COMMANDE DE MOTEUR

(30) Priorität: 05.04.2004 DE 102004017292
(43) Veröffentlichungstag der Anmeldung: 20.12.2006
(73) Patentinhaber: SIEMENS AKTIENGESELLSCHAFT, 80333 München (DE)
(72) Erfinder: MEIER, Markus, 92286 Rieden (DE); REICHENBACH, Norbert, 92224 Amberg (DE); ROYER, Fritz, 92256 Hahnbach (DE)
(86) Internationale Anmeldenummer: PCT/EP2005/051219
(87) Internationale Veröffentlichungsnummer: WO 2005/099330

(56) Entgegenhaltungen:
- US-A1- 2003 119 382
- US-A1- 2004 056 631
- PATENT ABSTRACTS OF JAPAN Bd. 1996, Nr. 08, 30. August 1996 (1996-08-30) -& JP 08 093680 A (HITACHI LTD), 9. April 1996 (1996-04-09)

## Beschreibung

Die Erfindung betrifft ein Motorsteuergerät, insbesondere ein Motorsteuergerät mit einer internen Überbrückung (By-pass).

Bei aus dem Stand der Technik bekannten Halbleitermotorsteuergeräten (Sanftstartern) ist es bekannt, eine By-pass-Funktion über ein zusätzliches Schütz zu verwirklichen. Der Sanftstarter übernimmt dabei die Ansteuerung des Schützes. Nachteilig bei diesen Geräten ist es, dass zusätzliche Bauelemente erforderlich sind. Aus dem Stand der Technik sind weiterhin Geräte bekannt, bei denen die By-pass-Funktion in dem Motorsteuergerät integriert ist. Nachteilig bei diesen Geräten ist es jedoch, dass diese entweder nur für eine zweiphasig gesteuerte Ausführung oder aber nur für eine dreiphasig gesteuerte Ausführung ausgebildet sind. Flexible, modulare und universell einsetzbare Motorsteuergeräte sind Gegenstand verschiedener Dokumente, wie z.B.US 2003119382 und US 2004056631.

Aufgabe der vorliegenden Erfindung ist es, ein Motorsteuergerät mit integrierter By-pass-Funktion bereitzustellen, welches eine universelle Einsetzbarkeit gestattet. Diese Aufgabe wird durch ein Motorsteuergerät nach Anspruch 1 gelöst.

Ein Kerngedanke der Erfindung ist es, die universelle Einsetzbarkeit durch einen neuartigen Gehäuseaufbau zu erreichen. Hierzu ist es insbesondere vorgesehen, mehrere voneinander isoliert angeordnete Kammern im Gehäuse des Motorsteuergerätes vorzusehen. Diese Kammern sind derart ausgestaltet, dass sie jeweils eine Leistungsteileinheit aufnehmen können. Zugleich erlaubt es die Ausgestaltung der Kammern, dass anstelle einer Leistungsteileinheit auch ein durchgehendes stromführendes Element zur Bestückung der Kammern verwendet werden kann. Somit ist es möglich, mit einem einzigen Gehäuseaufbau verschiedenste Gerätefunktionalitäten mit sehr geringem Aufwand zu ermöglichen. Dem Anwender können damit, unter Verwendung nur eines einzigen Aufbausystems, schnell und preiswert Lösungen angeboten werden, die auf die spezifischen Anforderungen im jeweiligen Einsatzfall angepasst sind. Darüber hinaus kann jeweils mit derselben Prüf- und Fertigungstechnik gearbeitet werden.

Vorteilhafte Ausführungsformen der Erfindung sind in den Unteransprüchen angegeben. Insbesondere ist eine zentrale Steuereinheit vorgesehen, die zur separaten Ansteuerung der einzelnen Leistungsteileinheiten dient. Durch eine Anordnung dieser Steuereinheit in dem Gehäuse ergibt sich ein Motorsteuergerät, das für verschiedenste Anwendungszwecke verwendet werden kann. Durch den Einsatz einer entsprechenden Steuereinheit kann insbesondere sowohl ein dreiphasig gesteuertes, als auch ein zweiphasig gesteuertes Motorsteuergerät unter Verwendung eines einzigen Gehäusetyps gebildet werden.

Die vorliegende Erfindung wird nachfolgend anhand von Ausführungsbeispielen beschrieben, die mit Hilfe von Zeichnungen näher erläutert werden. Hierbei zeigen:
- FIG 1: eine perspektivische Darstellung eines Motorsteuer- gerätes in dreipoliger Ausführung,
- FIG 2: eine perspektivische Darstellung eines Gehäuseab- schnittes des in Fig. 1 abgebildeten Motorsteuerge- rätes,
- FIG 3: eine perspektivische Darstellung eines Schaltmoduls zur Ausbildung eines dreipoligen, dreiphasig ge- steuerten Motorsteuergerätes,
- FIG 4: eine perspektivische Darstellung eines Schaltmoduls zur Ausbildung eines dreipoligen, zweiphasig ge- steuerten Motorsteuergerätes,
- FIG 5: eine schematische Darstellung eines dreiphasig ge- steuerten Motorsteuergerätes,
- FIG 6: eine schematische Darstellung eines zweiphasig ge- steuerten Motorsteuergerätes,
- FIG 7: eine schematische Darstellung eines vierpoligen, dreiphasig gesteuerten Motorsteuergerätes mit sepa- rat trennbarem vierten Pol,
- FIG 8: eine schematische Darstellung eines zweiphasig ge- steuerten Wendestarters,
- FIG 9: eine schematische Darstellung eines dreiphasig ge- steuerten Wendestarters mit seitlich anbaubaren Po- len.

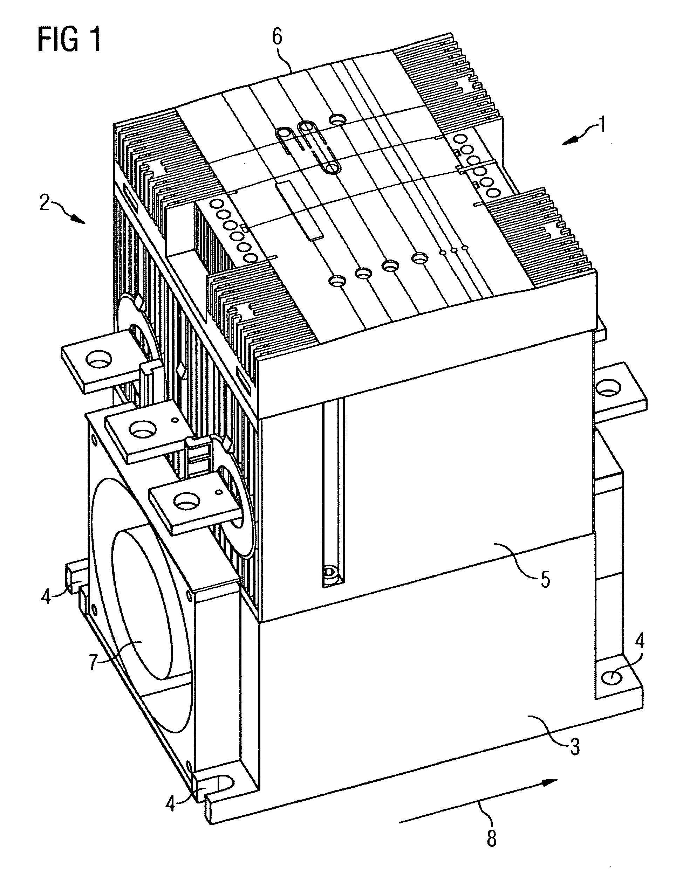

FIG 1 zeigt ein dreipoliges Motorsteuergerät 1, welches im Wesentlichen aus einer Gehäuseeinheit 2 und einer unterhalb der Gehäuseeinheit 2 angeordneten Kühleinheit 3 besteht. Die Gehäuseeinheit 2 ist vollständig aus einem Kunststoffmaterial gefertigt. Im Fußbereich der Kühleinheit 3 sind Befestigungselemente 4 zur Befestigung des Motorsteuergerätes 1 an einer Montagewand oder dergleichen vorgesehen.

Die Gehäuseeinheit 2 umfasst ein Gehäusegrundmodul 5 sowie ein darauf aufgebauter Gehäusedeckel 6, der zur Aufnahme einer zentralen Steuereinheit (nicht abgebildet) ausgebildet ist. Die zentrale Steuereinheit dient zur Ansteuerung der einzelnen Leistungsteileinheiten des Motorsteuergerätes 1.

Die Kühleinheit 3 dient zur Aufnahme von Kühlkörpern der Leistungsteileinheiten des Motorsteuergerätes 1. Darüber hinaus sind Lüfter 7 zur aktiven Kühlung des Motorsteuergerätes 1 vorgesehen. Selbstverständlich ist jedoch auch eine Ausführungsform ohne zusätzliche Lüfter möglich.

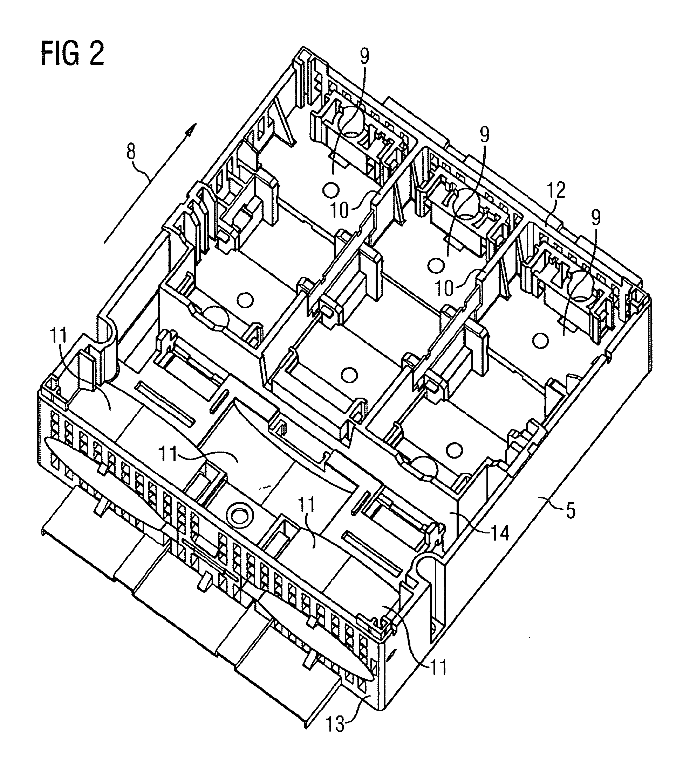

FIG 2 zeigt eine Ansicht des Gehäusegrundmoduls 5 ohne Gehäusedeckel 6. Im Inneren des Gehäusegrundmoduls 5 sind drei in Leiterlängsrichtung 8 verlaufende Kammern 9 vorgesehen, die konstruktiv durch Trennwände 10 voneinander abgetrennt sind. Aufgrund des verwendeten Gehäusematerials ist eine ausreichende elektrische Isolation zwischen den Kammern 9 einerseits und den in die Kammern 9 einbaubaren elektrisch leitenden Elementen, insbesondere den Leistungsteileinheiten, andererseits gewährleistet.

Jede dieser Kammern 9 dient der Aufnahme einer Phase des Motorsteuergerätes 1. Das vorliegende Gehäusegrundmodul 5 ist somit zur Ausbildung eines dreipoligen Motorsteuergerätes 1 geeignet. Jeder Kammer 9 ist eine Gehäusevertiefung 11 zur Aufnahme eines Stromwandlers zugeordnet. Im gezeigten Ausführungsbeispiel sind diese Gehäusevertiefungen 11 außerhalb der eigentlichen Kammern 9 angeordnet. Es ist jedoch ebenso möglich, die parallel zur Leiterlängsrichtung 8 verlaufenden Trennwände 10 von der Rückseite 12 des Gehäusegrundmoduls 5 zu dessen Stirnseite 13 hin zu verlängern derart, dass das Gehäusegrundmodul 5 ohne Verwendung von Querwände 14 vollständig in drei Kammern 9 unterteilt ist.

Die Kammern 9 sind zur Aufnahme von Leistungsteileinheiten bzw. durchgehenden stromführenden Elementen ausgebildet. Sie weisen zu diesem Zweck Auflage- und Halte- bzw. Stützelemente 15 auf.

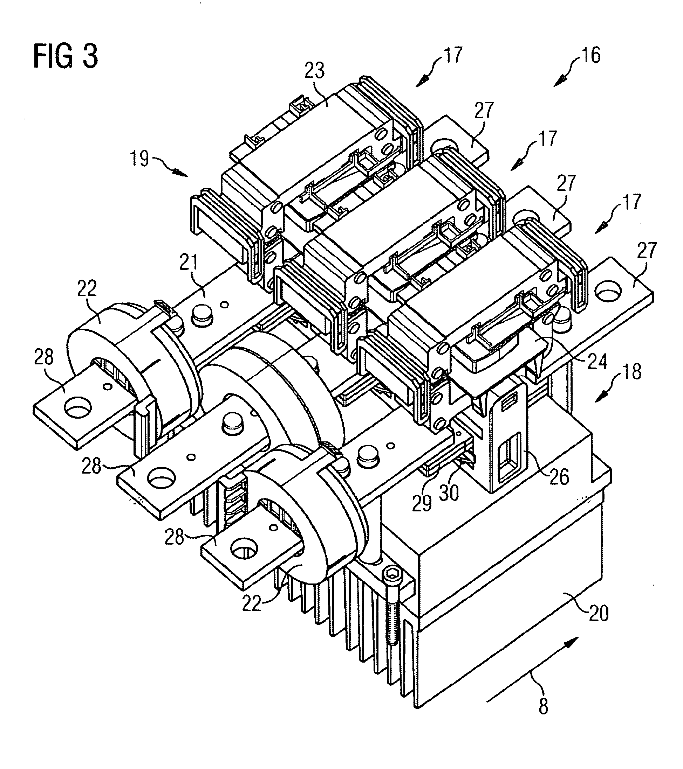

FIG 3 zeigt ein Schaltmodul 16, wie es in ein in FIG 2 dargestelltes Gehäusegrundmodul 5 eingebaut werden kann zur Ausbildung eines dreipoligen, dreiphasig gesteuerten Motorsteuergerätes 1. Abgebildet sind drei Leistungsteileinheiten 17, wobei jeder Phase jeweils eine Leistungsteileinheit 17 zugeordnet ist. Jede Leistungsteileinheit 17 umfasst ein elektronisches Schaltglied 18 in Form eines Thyristors und eine elektromechanische Überbrückung in Form eines elektromechanischen Schaltglieds 19 nach Art eines einphasigen Schützes sowie entsprechende Kühlkörper 20. Mit anderen Worten ist den elektronischen Schaltgliedern 18 jeweils ein elektromechanisches Schaltglied 19 zugeordnet.

Jeder Phase ist eine Kontaktschiene 21 zugeordnet. Diese Kontaktschienen 21 treten im Montageendzustand jeweils an der Stirnseite 13 sowie an der Rückseite 12 des Gehäusegrundmoduls 5 zur Ausbildung von Anschlusskontakten aus dem Gehäusegrundmodul 5 aus. Jeder Kontaktschiene 21 ist ein Ringkernwandler 22 zugeordnet, der in einer Gehäusevertiefung 11 einliegt, die Steuereinheit mit einer Strominformation versorgt und damit den Motorschutz gewährleistet.

Der phasenwinkelgesteuerten Zündung der Thyristoren während des Hochlaufens und des Ausschaltens des an das Motorsteuergerät angeschlossenen Motors (nicht abgebildet) dient die im Gehäusedeckel 6 der Gehäuseeinheit 3 angeordnete zentrale Steuereinheit, die in Form eines auf einer Leiterplatte angeordneten Mikrocontrollers ausgebildet ist.

Nachdem der von dem Motorsteuergerät 1 angesteuerte Motor unter Verwendung des elektronischen Schaltglieds 18 hochgelaufen ist und seinen Betriebspunkt, also Nenndrehzahl und Nennstrom, erreicht hat, wird die Überbrückungs- oder By-pass-Funktion durch die Steuereinheit aktiviert. Mit anderen Worten erfolgt dann eine Überbrückung des elektronischen Schaltglieds 18 durch das elektromechanische Schaltglied 19. Soll der Motor wieder ausgeschaltet werden, wird mit Hilfe der Steuereinheit das elektromechanische Schaltglied 19 deaktiviert und das elektronische Schaltglied 18 aktiviert. Das Ein- und Ausschalten des Motors erfolgt also über das elektronische Schaltglied 18, während das Stromführen über das elektromechanische Schaltglied 19 erfolgt. Die Steuereinheit dient dabei zur Steuerung des Zusammenspiels von Thyristor und Überbrückung.

Gleichzeitig wertet die Steuereinheit die Stromhöheninformationen der den einzelnen Phasen zugeordneten Ringkernwandler 22 aus und ermittelt die Belastung der Thyristoren für einen ausreichenden Thyristoreigenschutz. Darüber hinaus ist die Steuereinheit für den Motorschutz zuständig.

Da das elektromechanische Schaltglied 19 einen etwa um den Faktor zehn geringeren Wärmeverlust als das elektronische Schaltglied 18 aufweist, die produzierten Wärmeverluste mit anderen Worten während des Betriebs über das elektromechanische Schaltglied 19 also um ein Vielfaches geringer sind, kann die für die Kühlung des elektronischen Schaltglieds 18 vorgesehene Kühlkörper 20 wesentlich kleiner ausgelegt werden. Darüber hinaus kann auch das elektronische Schaltglied 18 selbst geringer dimensioniert sein, da es nicht keiner Dauerbelastung ausgesetzt ist.

Das elektromechanische Schaltglied 19 umfasst ein feststehendes Joch 23, unterhalb dessen eine Magnetspule 24 angeordnet ist. Unter der Spule 24 ist ein beweglicher Anker 25 angeordnet. Ein mit dem Anker 25 verbundener Kontaktträger 26 aus Kunststoff, zwei Festkontakte 27, 28 und ein bewegliches Schaltstück 29, das sich über eine Feder 30 an dem Kontaktträger 26 abstützt, bilden das Verbindungsteil.

Die in Form von Kontaktschienen 21 ausgebildeten Festkontakte 27, 28, die zum Anschluss von Anschlusskabeln vorgesehen sind, verfügen über Silberauflagen. Wird über die Steuereinheit eine Spannung an das Schaltglied 19 angelegt, erfolgt ein Stromfluss durch die Magnetspule 24 und der Anker 25 bewegt sich in Richtung des Jochs 23, bis Anker 25 und Joch 23 aufeinanderliegen. Bei dieser Bewegung wird der Kontaktträger 26 mitgenommen und drückt über die Feder 30 das Schaltstück 29 auf die beiden Festkontakte 27, 28. Damit ist eine leitende Verbindung hergestellt.

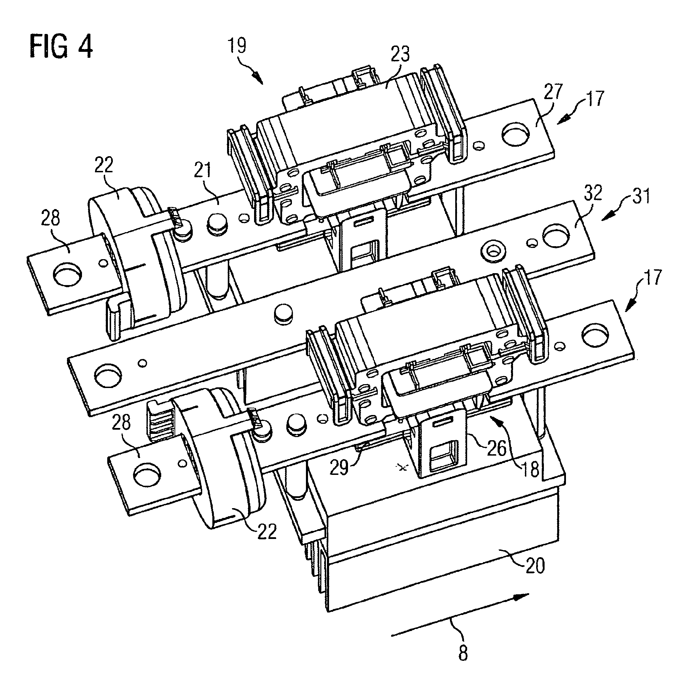

FIG 4 zeigt ein ebenfalls in das in FIG 2 gezeigte Gehäusegrundmodul 5 einbaubares Schaltmodul 31 zur Bildung eines dreipoligen, zweiphasig gesteuerten Motorsteuergerätes. Für die mittlere Phase ist kein elektronisches Schaltglied 18 vorgesehen. Stattdessen liegt im Montageendzustand ein durchgehendes stromführendes Element 32, hier in Form einer Kupferschiene, in der mittleren Kammer ein.

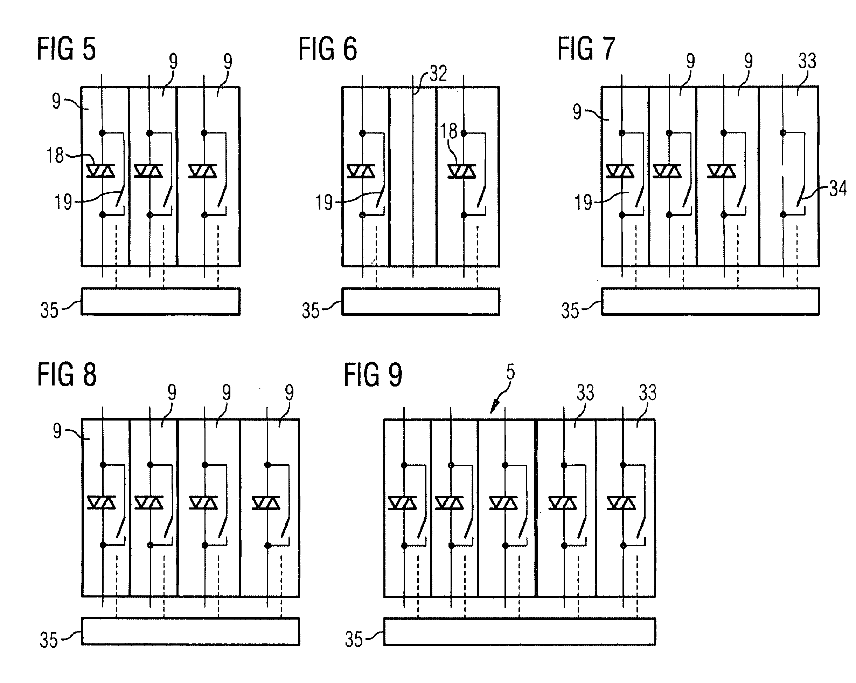

Die FIG 5 bis 9 zeigen in schematischen Darstellungen eine Auswahl der möglicher Ausführungsformen der Erfindung. Dabei entspricht die Darstellung in FIG 5 einer Ausführungsform eines dreiphasig gesteuerten Gerätes, wie sie in den FIG 2 und 3 beschrieben ist. Die FIG 6 zeigt eine Ausführungsform, die der anhand der FIG 2 und 4 beschriebenen Gestaltung eines zweiphasig gesteuerten Gerätes mit einem durchgehenden stromführenden Element 32 entspricht.

In FIG 7 ist ein vierpoliges, dreiphasiges gesteuertes Gerät mit separat trennbarem vierten Pol schematisch abgebildet. Hierzu wird eine modular aufbaubare Gehäuseeinheit 3 verwendet, bei dem an ein Gehäusegrundmodul 5, welches drei Kammern 9 aufweist, je nach Bedarf weitere Kammern 33 angebaut werden können. Die anbaubaren Kammern 33 liegen dabei vorzugsweise parallel zu den bereits vorhandenen Kammern 9. Alternativ zu dieser Ausführungsform der Gehäuseeinheit 3 ist es ebenfalls möglich, anstelle eines dreikämmrigen Gehäusegrundmoduls 5 eine Gehäuseeinheit einzusetzen, welche nach Bedarf aus der entsprechenden Anzahl von Kammern zugesammengesetzt wird. Somit sind beispielsweise auch Gehäuseeinheiten mit weniger als drei Kammern möglich. Hierzu werden die einzelnen Kammern vorzugsweise lösbar miteinander verbunden

Die in FIG 7 gezeigte Ausführungsform weist einen zusätzlichen vierten Pol auf, wobei diese Phase nur mit einem separat zu schaltendem mechanischen Kontaktsystem, beispielsweise einem Relais 34 ausgerüstet ist. Hierdurch wird ein voraus- bzw. nacheilendes Trennen eines N-Leiters in einem Vier-Leiternetz ermöglicht.

FIG 8 zeigt eine weitere Ausführungsform der Erfindung mit vier Kammern 9 zur Ausbildung eines zweiphasig gesteuerten Wendestarters. FIG 9 zeigt schließlich einen dreiphasig gesteuerten Wendestarter mit seitlich anbaubaren Polen. Bei dieser Ausführungsform ist ein dreikämmriges Gehäusegrundmodul 5 mit zwei weiteren Kammern 33 erweitert.

In den FIG 5 bis 9 ist schematisch die zentrale Steuereinheit 35 abgebildet, die der Ansteuerung der Schaltglieder 18, 19 dient.

## Patentansprüche

1. Motorsteuergerät (1) mit einer Anzahl von Leitungsteileinheiten (17), wobei mindestens eine Leistungsteileinheit (17) ein elektronisches Schaltglied (18) und ein als Überbrückungselement ausgebildetes elektromechanisches Schaltglied (19) aufweist, und mit einem Gehäuse (5) zur Aufnahme der Leistungsteileinheiten (17), wobei das Gehäuse (5) elektrisch voneinander isolierte Kammern (9) aufweist, welche jeweils sowohl
a) zur Aufnahme einer Leistungsteileinheit (17), als auch, alternativ hierzu,
b) zur Aufnahme eines durchgehenden stromführenden Elementes (32) ausgebildet sind,
wobei im Montagezustand jeweils Kontaktschienen der Leistungsteileinheit (17) und/oder des durchgehend stromführenden Elements (32) an der Stirnseite (13) sowie an der Rückseite (12) des Gehäuses (5) zur Ausbildung von Anschlusskontakten aus dem Gehäuse (5) heraustreten.

2. Motorsteuergerät (1) nach Anspruch 1, **dadurch gekennzeichnet, dass** wenigstens einer Leistungsteileinheit (17) ein Sensorelement (21) zugeordnet ist, das in der gleichen Kammer (9) wie die Leistungsteileinheit (17) angeordnet ist.

3. Motorsteuergerät (1) nach einem der Ansprüche 1 bis 2, **gekennzeichnet durch** eine entsprechend der Anzahl der verwendeten Phasen ausgebildete zentrale Steuereinheit (35) zur Ansteuerung der Leistungsteileinheiten (17).

4. Motorsteuergerät (1) nach einem der Ansprüche 1 bis 3, **dadurch gekennzeichnet, dass** die Kammern (9) in einer einstückigen Gehäuseeinheit (2) angeordnet sind.

5. Motorsteuergerät (1) nach einem der Ansprüche 1 bis 3, **dadurch gekennzeichnet, dass** die Anzahl der Kammern (9) variabel den funktionalen Anforderungen an das Motorsteuergerät (1) anpassbar ist.

6. Motorsteuergerät (1) nach Anspruche 4, **dadurch gekennzeichnet, dass** das Gehäuse (5) aus einzelnen Gehäusemodulen (5, 33) zusammensetzbar ist, wobei jedes Gehäusemodul (5, 33) wenigstens eine Kammer (9) aufweist.

## Claims

1. Motor control device (1) having a number of power subunits (17), with at least one power subunit (17) having an electronic switching element (18) and an electromechanical switching element (19) which is in the form of a bridge element, and having a housing (5) for holding the power subunits (17), with the housing (5) having chambers (9) which are electrically insulated from one another and in each case are formed both
a) for holding a power subunit (17) and, as an alternative to this,
b) for holding a continuous current-carrying element (32), with, in the mounted state, contact rails of the power subunit (17) and/or of the continuous current-carrying element (32) in each case emerging from the housing (5) at the end face (13) and at the rear face (12) of the said housing (5) in order to form connection contacts.

2. Motor control device (1) according to Claim 1, **characterized in that** a sensor element (21) is associated with at least one power subunit (17) and is arranged in the same chamber (9) as the power subunit (17).

3. Motor control device (1) according to one of Claims 1 to 2, **characterized by** a central control unit (35), which is formed in accordance with the number of phases used, for driving the power subunits (17).

4. Motor control device (1) according to one of Claims 1 to 3, **characterized in that** the chambers (9) are arranged in an integral housing unit (2).

5. Motor control device (1) according to one of Claims 1 to 3, **characterized in that** the number of chambers (9) can be matched to the functional requirements made of the motor control device (1) in a variable manner.

6. Motor control device (1) according to Claim 4, **characterized in that** the housing (5) is made up of individual housing modules (5, 33), with each housing module (5, 33) having at least one chamber (9).

## Revendications

1. Appareil ( 1 ) de commande de moteur, comprenant un certain nombre de sous-groupes ( 17 ) de puissance, au moins un sous-groupe ( 17 ) de puissance ayant un élément ( 18 ) électronique de commutation et un élément ( 19 ) électromagnétique de commutation constitué en shunt, et un carter ( 5 ) de réception de sous-groupes ( 17 ) de puissance, le carter ( 5 ) ayant des chambres ( 9 ) qui sont isolées électriquement les unes des autres et qui respectivement sont constituées tant
a ) pour la réception d'un sous-groupe ( 17 ) de puissance, qu'en variante à cela,
b ) pour la réception d'un élément ( 32 ) continu de conduite du courant,
dans lequel, dans l'état de montage, des rails de contact de la sous-unité ( 17 ) de puissance et/ou de l'élément ( 32 ) continu conduisant le courant sortent du carter ( 5 ) du côté ( 13 ) avant ainsi que du côté ( 12 ) arrière du carter ( 5 ) pour constituer des contacts de connexion.

2. Appareil ( 1 ) de commande de moteur suivant la revendication 1, **caractérisé en ce qu'**à au moins un sous-groupe ( 17 ) de puissance est associé un élément ( 21 ) formant capteur qui est disposé dans la même chambre ( 9 ) que le sous-groupe ( 17 ) de puissance.

3. Appareil ( 1 ) de commande de moteur suivant l'une des revendications 1 à 2, **caractérisé par** une unité ( 35 ) centrale de commande, qui est constituée conformément au nombre des phases utilisées et qui est destinée à commander les sous-groupes ( 17 ) de puissance.

4. Appareil ( 1 ) de commande de moteur suivant l'une des revendications 1 à 3, **caractérisé en ce que** les chambres ( 9 ) sont disposées dans une unité ( 2 ) d'une seule pièce formant un carter.

5. Appareil ( 1 ) de commande de moteur suivant l'une des revendications 1 à 3, **caractérisé en ce que** le nombre des chambres ( 9 ) peut être adapté de manière variable aux exigences fonctionnelles imposées à l'appareil ( 1 ) de commande du moteur.

6. Appareil ( 1 ) de commande de moteur suivant la revendication 4, **caractérisé en ce que** le carter ( 5 ) peut être composé de modules ( 5, 33 ) individuels de carter, chaque module ( 5, 33 ) de carter comportant au moins une chambre ( 9 ).
